# EUROPEAN PATENT APPLICATION

(11) **EP 1 580 292 A1**
(43) Date of publication of application: **28.09.2005**
(21) Application number: 05250218.4
(22) Date of filing: 17.01.2005
(51) Int. Cl.: C23C 4/02, C23C 4/10, C23C 4/12, C23C 16/02, C23C 16/40

(54) **Method of producing a substrate**

(30) Priority: 24.03.2004 US 807716
(71) Applicant: THE BOC GROUP, INC., New Jersey 07974-2082 (US)
(72) Inventor: Davis, Ian Martin, Chandler Arizona 85225 (US); Laube, David, Mesa Arizona 85207 (US)
(74) Representative: Booth, Andrew Steven

(57) **Abstract**

A process of producing a clean substrate for use in semiconductor processing in which the substrate is roughened to produce microfissures therein and then treated with a high concentration of a strong acid followed by coating with a material containing at least one metal oxide.

## Description

The present invention is generally directed to producing a substrate suitable for use in semiconductor processing in which the surface of the substrate is first roughened to promote adhesion of a coating material. The surface is then treated to remove remaining particles on the substrate and thereafter coated with a metal oxide composition.

Substrate materials such as quartz are used for a variety of purposes in the semiconductor industry (e.g. a dielectric barrier in etch processing chambers). The surface of the substrate often must be mechanically enhanced to increase the surface area.

Mechanical enhancement can be accomplished by treating the surface with an abrasive material under pressure, known generally as bead blasting such as disclosed in U.S. Patent Nos. 5,202,008; 5,391,275 and 6,565,667.

Bead blasting is often used to remove an existing coating on the substrate surface and/or to prepare the surface by increasing the surface area to promote adhesion of a new layer of coating material. However, bead blasting can create a surface that contains small particles which can adversely affect the coating applied to the surface.

Some success has been obtained by subsequently treating the bead blasted substrate surface with strong acids which can dislodge embedded particles and loose fragments and therefore provide a cleaner surface than can be obtained by bead blasting alone. However, the combination of bead blasting and acid treatment does not consistently remove all particles from the treated substrate surface. In addition, the remaining surface can contain jagged portions which when the substrate is further processed can result in loose particles.

For example, it is common place to use quartz as a consumable component in a semiconductor wafer manufacturing chamber, where the chamber's purpose may be to remove metal oxides such as silicon dioxide, copper oxides and the like from silicon wafer surfaces. In this chamber a radiofrequency excites argon atoms, driving them to sputter etch the surface of the wafer, thereby removing the surface oxide layer. Bead blasted quartz also contains small particles of silicon dioxide which may dislodge during the plasma etch process, depositing on the surface of the silicon wafer, creating a defect. For bead blasted quartz components in the chamber, this application is specific to the coating of bead blasted quartz with a material focused through a plasma gun onto the surface of the substrate material to both promote the adhesion of the material(s) etched from the wafer as well as seal in the particles caused by the bead blasting process. The application of the coating is due to a formation of the plasma inside the application gun and is typically applied and created through gases such as hydrogen, nitrogen, argon, helium and mixtures thereof. Previous methods to achieve particle free bead blasted quartz surfaces were performed via chemically etching the surface of semiconductor materials such as marketed by the BOC Edwards Division of the BOC Group, Inc.

This type of process is an application where a post bead blasted metal or insulator material is chemically etched to remove both embedded impurities and to remove loose fragments of the substrate caused by the mechanical modification of the surface.

In some plasma etch systems, loosely held particles of the substrate material remain and can adversely affect the integrity of the substrate and the semiconductor assembly in which it is incorporated. The system of roughening the surface followed by chemical etching has provided improved removal of such loosely held particles of substrate material but in some cases the substrate either contains some particulate matter or small cracks that can produce particulate matter which can become dislodged during further processing of the semiconductor assembly. As previously indicated, these particles can adversely affect the function of the substrate material and the semiconductor wafers produced by the same.

The present invention provides a method of producing a substrate suitable for use in semiconductor processing, the method comprising roughening the surface of the substrate material to produce microfissures therein, treating the roughened surface to remove at least substantially all particles of the substrate material remaining on the roughened surface, and coating the roughened surface with a coating composition containing at least one metal oxide.

The following drawing is illustrative of an embodiment of the invention and is not intended to limit the invention as encompassed by the claims of the application.

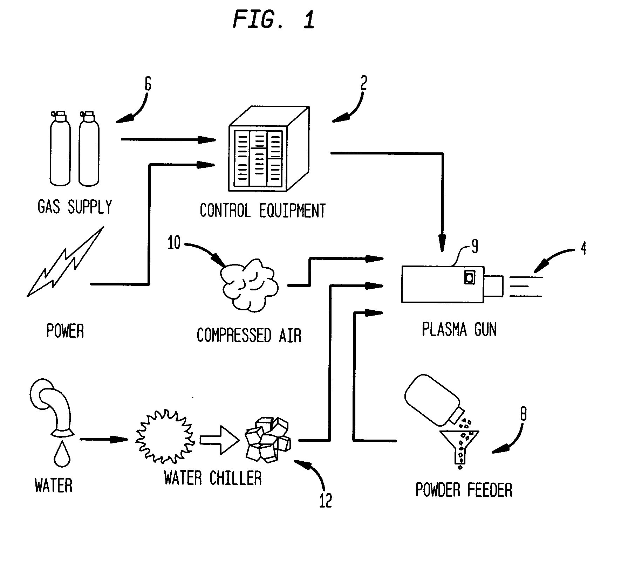

The drawing is a graphic illustration of the components of a plasma spray assembly for applying a coating composition to a roughened substrate surface.

The present invention is generally directed to a process of producing a substrate to make it suitable for use in semiconductor processing in which the surface of the substrate is first roughened and then eventually coated with a thin layer of a coating composition which is desirably dielectric to provide a non-conductive surface of substrate material suitable for further processing into semiconductor assemblies.

The surface of the substrate material must first be roughened to remove surface materials therefrom which can adversely affect the properties of the substrate material and which improves the adhesive capability of the surface to make it suitable for the formation of semiconductor assemblies such as wafers and the like. The substrate material can be any material suitable for use in the semiconductor industry such as quartz, ceramic, metal oxides including aluminium oxide, and metals such as aluminium. Quartz is a particularly useful substrate material because it is dielectric and relatively pure when manufactured.

The manner in which the surface of the substrate material may be roughened can vary but it is desirable to use an abrasive material typically in the form of beads which is applied under pressure through a nozzle under particular conditions to produce a surface roughness suitable for use in producing semiconductor assemblies. The degree of surface roughness will typically be in the range of from 4.57 to 8.13 microns (180 to 320 micro-inches), preferably 5.08 to 7.62 microns (200 to 300 micro-inches), most preferably 5.08 to 6.35 microns (200 to 250 micro-inches) Ra. Such surface roughness conditions can be obtained by adjusting the pressure, grit size, and distance applied to the abrasive material. Such systems desirably produce a roughened surface but are characterized as leaving microparticles of the substrate material on the surface including particles lodged within the microfissures.

These lodged particles can be removed at least to some extent by then treating the roughened substrate material with an immersion bath typically containing relatively high concentrations of strong acids such as nitric acid and/or hydrofluoric acid. Typical concentrations of the strong acids are from 15 to 50 volume percent, preferably from 25 to 35 volume percent. The acid immersion bath contains strong acids at sufficiently high concentrations so that it is capable of facilitating the removal of at least some of the particles of substrate material remaining on the substrate surface. In a preferred process, the roughened surface is chemically etched to remove both embedded impurities and to remove loose fragments of the substrate material caused by the mechanical modification of the surface.

While the acid etch treatment system described above works effectively to remove loosely held particles, it has been observed that the microfissures of the roughened surface can still form additional particles during further processing to produce semiconductor assemblies. Jagged edge pieces of the microfissures can be dislodged or broken off from the surface and thus the microfissures themselves may be a source of undesirable loose particles after acid etch treatment.

In accordance with the present invention, the roughened surface of the substrate material which has had at least substantially all of the loose particles removed, can further be treated by applying a thin coating, preferably a dielectric coating, to the roughened, acid etched surface which prevents the dislodgement of additional particles of the substrate material from microfissures contained on the roughened surface.

The coating composition used to form the thin coating may be any coating composition which forms an effective, preferably dielectric coating and which prevents dislodgement of particles of the substrate surface during further processing of the substrate material into semiconductor assemblies. The coating will be of sufficient thickness to fill and cover the microfissures, typically up to 0.254 mm (0.010 inch). The coating composition is selected from metal oxide coatings including silicon dioxide. Preferred metal oxide coatings include zirconium oxide, yttrium oxide and/or aluminium oxide. The presence of zirconium oxide and particularly as a major component of the coating composition is preferred. In a preferred form of the invention, the coating composition will contain at least 92% zirconium oxide. Zirconium oxide is a preferred component of the coating composition because it has shown to be more chemically pure than other metal oxides such as aluminium oxide. Aluminium oxide often contains small amounts of sodium oxide. During the plasma process, the sodium is transferred to the substrate material.

With reference to the drawing, a plasma spray assembly 2 for producing a plasma spray 4 of the coating composition can be created by providing a suitable gas from a source 6 for developing a plasma, typically from hydrogen, nitrogen, argon, helium and mixtures thereof. The plasma gas is combined with the coating composition materials 8 (e.g. zirconium oxide) which is supplied to a plasma gun 9 as a solid, typically in the form of a powder in which the high temperatures generated in a plasma chamber of the plasma gun 9 (e.g. about 5,540 to 16,600°C (about 10,000 to 30,000°F)) will melt the powder so that the coating composition can be applied as a thin layer on a previously roughened substrate such as a substrate roughened by bead blasting.

Compressed air or other suitable compressed gas is provided from a source 10 to the plasma gun 9 to propel the melted materials in the plasma gun to the surface of the substrate. In addition, frozen water in the form of ice crystals from an icer 12 is provided to the plasma gun to control the temperature of the plasma spray which is provided from the plasma gun.

The thickness of the coating composition will typically be sufficient to fill the microfissures contained on the roughened surface of the substrate typically up to 0.127 mm (0.005 inch), more typically up to 0.152 mm (0.006 inch). Accordingly, the coating composition will have a thickness typically up to 0.254 mm (0.010 inch). The filling of the microfissures prevents the jagged edge portions of the microfissures from dislodging to become loose particles. The resulting coated surface in addition to preventing the formation of undesirable particles from the jagged portions of the microfissures, also provides a smooth substrate surface which provides better adhesion properties for continued development of semiconductor assemblies and significantly reduces the presence of undesirable gas on the surface (i.e. reduces outgassing).

In a further and preferred embodiment of the present invention, after substantially all of the loose particles of the substrate material have been removed from the roughened substrate surface, the roughened substrate may then be ultrasonically cleaned, typically in deionised water preferably while immersed in an ultrasonic cleaning tank of the type described in U.S. Patent No. 5,651,797.

### EXAMPLE 1

A thin wafer substrate made of quartz having a layer of silicon dioxide (Sample 1) was bead blasted with bead of silicon carbide to create a surface roughness in the range of 4.57 to 5.59 microns (180 to 220 micro inch) Ra using a 0.762 mm (0.03 inch) cut length. The bead blasted wafer was then treated with an acid bath containing 33% v/v of 70% strength nitric acid, 33% v/v of 69% strength hydrofluoric acid and 34% of deionised water for between one to two minutes.

The thus treated wafer was rinsed in deionised water and ultrasonically cleaned in deionised water at >5.0 Meg Ohm-cm at a temperature of 24 to 32°C (75 - 90°F) for two minutes in an ultrasonic cleaning tank described in U.S. Patent No. 5,651,797. The wafer was then dried using a 0.01 micron filtered nitrogen and baked at 121°C (250°F) for two hours in a nitrogen atmosphere.

The thus dried and baked wafer was coated with a coating composition containing greater than 98% aluminium oxide to form a coating on the surface of the wafer having a thickness of 50.8 mm (0.002 inch) to produce a coating layer which possessed sufficient adhesion to at least substantially prevent particle dislodgement during subsequent processing for the formation of semiconductor assemblies.

### EXAMPLE 2

Samples 2-18 were prepared in the same manner as Sample 1 except the coating material, the coating thickness and surface roughness of the wafer were modified as shown in Table 1.

**Table 1**

| Adhesion Results | | | |
|---|---|---|---|
| **Sample** | **Coating Material** | **Coating Thickness mm (Inch)** | **Surface Roughness*** |
| 1 | Aluminium Oxide | 50.8 (0.002) | A |
| 2 | Aluminium Oxide | 50.8 (0.002) | A |
| 3 | Aluminium Oxide | 50.8 (0.002) | A |
| 4 | Aluminium Oxide | 152 (0.006) | B |
| 5 | Aluminium Oxide | 152 (0.006) | B |
| 6 | Aluminium Oxide | 152 (0.006) | B |
| 7 | Aluminium Oxide | 254 (0.010) | C |
| 8 | Aluminium Oxide | 254 (0.010) | C |
| 9 | Aluminium Oxide | 254 (0.010) | C |
| 10 | Zirconium Oxide ** | 50.8 (0.002) | A |
| 11 | Zirconium Oxide | 50.8 (0.002) | A |
| 12 | Zirconium Oxide | 50.8 (0.002) | A |
| 13 | Zirconium Oxide | 152 (0.006) | B |
| 14 | Zirconium Oxide | 152 (0.006) | B |
| 15 | Zirconium Oxide | 152 (0.006) | B |
| 16 | Zirconium Oxide | 254 (0.010) | C |
| 17 | Zirconium Oxide | 254 (0.010) | C |
| 18 | Zirconium Oxide | 254 (0.010) | C |

| | | | |
|---|---|---|---|
| * - A = 4.57 to 5.59 microns (180-220 µ in) Ra B = 5.84 to 6.86 microns (230-270 µ in) Ra C = 7.11 to 8.13 microns (280-320) µ in Ra | | | |
| ** - All Zirconium Oxide samples contained 92% zirconium oxide and 8% yttrium oxide | | | |

Each of Samples 2-18 exhibited a coating layer which possessed sufficient adhesion to at least substantially prevent particle dislodgement during subsequent processing for the formation of semiconductor assemblies. Zirconium oxide coatings are preferred over aluminium oxide coatings because they exhibited less outgassing, less water vapour retention and less retained anion and cation species on the surface of the substrate material.

In summary, a process is described for producing a clean substrate for use in semiconductor processing, in which the substrate is roughened to produce microfissures therein and then treated with a high concentration of a strong acid followed by coating with a material containing at least one metal oxide.

## Claims

1. A method for producing a substrate suitable for use in semiconductor processing, the method comprising roughening a surface of the substrate material to produce microfissures therein, treating the roughened surface to remove at least substantially all particles of the substrate material remaining on the roughened surface, and coating the roughened surface with a coating composition containing at least one metal oxide.

2. A method according to Claim 1, wherein the substrate is comprised of a material selected from the group consisting of quartz, ceramics, metals and metal oxides.

3. A method according to Claim 1 or Claim 2, wherein the coating composition is selected from silicon dioxide, aluminium oxide, zirconium oxide, yttrium oxide and combinations thereof.

4. A method according to Claim 3, wherein the coating composition comprises zirconium oxide and yttrium oxide.

5. A method according to any preceding claim, wherein the step of coating the roughened surface comprises generating a plasma comprising a plasma generating gas and the coating composition, and directing the plasma toward said roughened surface in a manner sufficient to apply the coating composition to the roughened surface.

6. A method according to Claim 5, wherein the plasma is generated in the presence of compressed air.

7. A method according to Claim 5 or Claim 6, wherein the plasma is generated at a temperature within the range from about 5,540 to 16,600°C (about 10,000 to 30,000°F).

8. A method according to any of Claims 5 to 7, wherein the plasma generating gas is selected from the group consisting of hydrogen, nitrogen, argon, helium and mixtures thereof.

9. A method according to any preceding claim, wherein the step of roughening the surface of the substrate material comprises contacting the substrate material with solid particles of a roughening material to produce a surface roughness in the range of from about 4.57 to 8.13 microns (180 to 320 micro inch) Ra.

10. A method according to Claim 9, wherein the surface roughness is in the range from about 5.08 to 7.62 microns (200-300 micro inch) Ra.

11. A method according to any preceding claim, wherein the step of treating the roughened surface comprises immersing the substrate in an immersion bath containing an acidic solution.

12. A method according to Claim 11, wherein the concentration of the acid is from 15 to 50 volume percent.

13. A method according to Claim 11 or Claim 12, wherein the concentration of the acid is from 25 to 35 volume percent.

14. A method according to any of Claims 11 to 13, wherein the acidic solution comprises nitric acid and/or hydrofluoric acid.

15. A method according to any of Claims 11 to 14, wherein the substrate is subsequently removed from the immersion bath and cleaned.

16. A method according to any preceding claim, wherein the depth of the microfissures is up to about 0.152 mm (0.006 inch).

17. A method according to any preceding claim, wherein the depth of the microfissures is up to about 0.127 mm (0.005 inch).

18. A method according to any preceding claim, wherein the thickness of the coating is sufficient to fill and cover the microfissures.

19. A method according to Claim 18, wherein the thickness of the coating is up to about 0.254 mm (0.010 inch).

20. A method according to Claim 1, wherein the step of coating the roughened surface comprises applying the coating composition in the form of a plasma containing a plasma gas.

21. A method according to Claim 20, comprising applying the coating composition in the form of a plasma at a temperature within the range from about 5,540 to 16,600°C (about 10,000 to 30,000°F).

22. A method according to any preceding claim, wherein the coating is a dielectric coating.
